(19) Europäisches Patentamt
European Patent Office
Office européen des brevets

(11) EP 2 113 952 A2

(12) # EUROPEAN PATENT APPLICATION

(43) Date of publication:
**04.11.2009 Bulletin 2009/45**

(51) Int Cl.:
***H01L 41/08*** *(2006.01)* ***H01L 41/187*** *(2006.01)*
***C04B 35/495*** *(2006.01)*

(21) Application number: **09004612.9**

(22) Date of filing: **30.03.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **31.03.2008 JP 2008090331**

(71) Applicant: **TDK Corporation**
**Tokyo 103-8272 (JP)**

(72) Inventors:
- **Furukawa, Masahito**
  **Tokyo 103-8272 (JP)**
- **Tsukada, Takeo**
  **Tokyo 103-8272 (JP)**
- **Tanaka, Daisuke**
  **Tokyo 103-8272 (JP)**
- **Sakamoto, Norimasa**
  **Tokyo 103-8272 (JP)**

(74) Representative: **Grünecker, Kinkeldey, Stockmair & Schwanhäusser**
**Anwaltssozietät**
**Leopoldstrasse 4**
**80802 München (DE)**

(54) **Piezoelectric ceramic and piezoelectric element employing it**

(57) A piezoelectric ceramic (1) in a piezoelectric element (20) contains, as a major component, a composition containing one or more complex oxides with metal elements other than lead as constituent elements. At least one of the complex oxides includes an alkali metal and Nb as constituent elements. Also, either or both of the elements Mn and Cu are segregated at the grain boundaries of the composition.

***Fig.1***

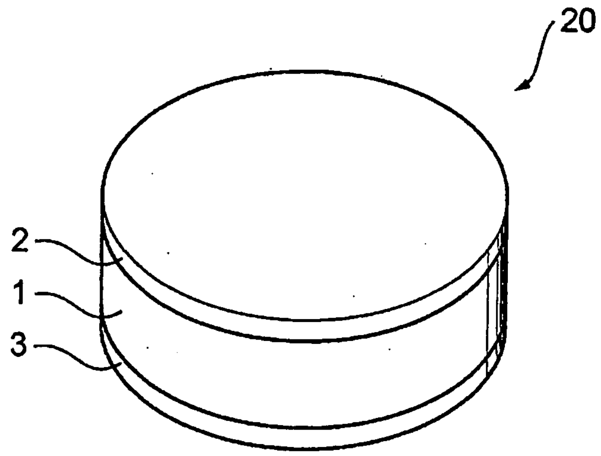


EP 2 113 952 A2

## Description

BACKGROUND OF THE INVENTION

Field of the Invention

The present invention relates to a piezoelectric ceramic and to a piezoelectric element employing it.

Related Background Art

Known piezoelectric ceramics exhibit piezoelectricity, whereby application of an electric field generates mechanical strain and stress. Such piezoelectric ceramics are used in various types of oscillating element including actuators, and in sounding bodies, sensors and the like.

Actuators employing piezoelectric ceramics characteristically allow high precision to be obtained for fine displacement and produce large generated stress, and they are used for positioning of precision machine tools and optical devices. The piezoelectric ceramics used in actuators are, in most cases, made of lead zirconate titanate (PZT) which has excellent piezoelectric properties. However, because lead zirconate titanate contains a large amount of lead, concerns have been raised in recent years regarding the adverse effects on the environment by elution of lead caused by acid rain. Lead-free piezoelectric ceramics have therefore been sought as a substitute for lead zirconate titanate, and several types of lead-free piezoelectric ceramics have been proposed to meet this demand.

For example, Japanese Unexamined Patent Publication HEI No. 2-159079 (Document 1) discloses a piezoelectric ceramic containing barium titanate ($BaTiO_3$) as a major component. The piezoelectric ceramic has superior values for the relative permittivity εr and electromechanical coupling coefficient kr.

Also, Japanese Unexamined Patent Publication SHO No. 49-125900 (Document 2) and Japanese Examined Patent Publication SHO No. 57-6713 (Document 3) disclose piezoelectric ceramics composed of lithium potassium sodium niobate. These piezoelectric ceramics have high Curie temperatures of 350°C and above, and also excellent electromechanical coupling coefficients (kr).

Japanese Unexamined Patent Publication No. 2005-179143 (Document 4) and Japanese Unexamined Patent Publication No. 2005-179144 (Document 5) disclose piezoelectric materials which contain a first perovskite oxide comprising a first element containing Na and K, a second element containing at least Nb from among the group consisting of Nb and Ta, and oxygen (O), a second perovskite oxide comprising a third element containing an alkaline earth metal element, a fourth element containing titanium (Ti), and oxygen, and a tungsten-bronze oxide. These piezoelectric materials are of note because they exhibit relatively large displacements.

SUMMARY OF THE INVENTION

However, the lead-free piezoelectric ceramics of the aforementioned Documents 1-3 have low piezoelectric characteristics compared to lead-based piezoelectric ceramics, and have not been able to provide sufficiently large generated displacement. Moreover, in piezoelectric ceramics composed mainly of barium titanate, such as described in Document 1, the low Curie temperature of barium titanate of approximately 120°C limits the usable temperature range to no higher than 100°C.

Also, with the piezoelectric ceramics comprising lithium potassium sodium niobate described in Documents 2 and 3 it is difficult to maintain and adjust the composition of the obtained piezoelectric ceramic since sodium, potassium and lithium readily volatilize during firing.

In addition, while the piezoelectric ceramics described in Documents 4 and 5 exhibit larger displacement than the piezoelectric ceramics of Documents 1-3, these piezoelectric ceramics also fail to exhibit very high resistance, and therefore sufficient polarization cannot be achieved. Because the piezoelectric characteristics are still lower compared to lead zirconate titanate, further improvement is desired.

The present invention has been accomplished in light of these circumstances, and its object is to provide a piezoelectric ceramic with a sufficiently reduced lead content and with satisfactorily excellent piezoelectric characteristics, as well as a piezoelectric element comprising the piezoelectric ceramic.

With the goal of achieving the object stated above, the present inventors have conducted much research on compositions and microstructures that allow a large generated displacement to be obtained. It was found as a result that the piezoelectric characteristics can be improved by segregating specific elements at the grain boundary regions.

Specifically, the present invention provides a piezoelectric ceramic having as the major component a composition comprising one or more complex oxides containing metal elements different from lead as constituent elements, wherein at least one of the complex oxides contains an alkali metal and Nb as constituent elements, and either or both the Mn and Cu are segregated at the grain boundaries of the composition.

Such a piezoelectric ceramic, which has as the major component a composition comprising lead-free complex oxides as constituent elements, has a reduced lead content and satisfactory environmental friendliness. The piezoelectric characteristics are also satisfactorily high compared to conventional lead-free piezoelectric ceramics. Conventional piezoelectric ceramics without lead as a major component have low resistance compared to piezoelectric ceramics composed mainly of PZT, and therefore are not capable of sufficient polarization. However, the present inventors attribute the satisfactorily excellent piezoelectric characteristics exhibited by the piezoelectric ceramic of the invention to its microstructure. That is, the piezoelectric ceramic of the invention has a microstructure wherein either or both the elements Mn and Cu are segregated at the grain boundaries of crystal grains of the complex oxide as the major component, thus allowing the resistivity of the piezoelectric ceramic to be increased. Presumably, therefore, a sufficient polarization voltage can be applied and sufficiently large generated displacement can be obtained.

According to the invention, the composition constituting the major component of the piezoelectric ceramic is represented by the following general formula (1), and the total content of Ta in the complex oxides represented by the following general formula (2) and the complex oxides represented by the following general formula (4) is preferably no greater than 20 mol% with respect to the total composition.

$$(1\text{-}m\text{-}n)A + mB + nC \qquad (1)$$

[In formula (1), m satisfies $0 \leq m < 0.1$ and n satisfies $0 \leq n \leq 0.01$, while A, B and C are complex oxides represented by the following general formula (2), the following general formula (3) and the following general formula (4), respectively.]

$$(Na_{1-x-y}K_xLi_y)_p(Nb_{1-z}Ta_z)O_3 \qquad (2)$$

[In formula (2), x satisfies $0.1 \leq x \leq 0.9$, y satisfies $0 \leq y \leq 0.1$, z satisfies $0 \leq z \leq 0.2$ and p satisfies $0.95 \leq p \leq 1.05$.]

$$(M1)(M2)O_3 \qquad (3)$$

[In formula (3), M1 represents at least one element selected from the group consisting of Mg, Ca, Sr and Ba, and M2 represents at least one element selected from the group consisting of Ti, Zr and Hf.]

$$(M3)(Nb_{1-w}Ta_w)_2O_6 \qquad (4)$$

[In formula (4), M3 represents at least one element selected from the group consisting of Mg, Ca, Sr and Ba, and w satisfies $0 \leq w \leq 0.2$.]

Since the composition described above has a high Curie temperature, the piezoelectric ceramic containing the composition as a major component has a sufficiently wide usable temperature range. Moreover, since a complex oxide containing Ta as a constituent element is present, it is possible to improve the permittivity while increasing the generated displacement. The humidity resistance can also be improved.

According to the invention, the composition as the major component of the piezoelectric ceramic is preferably represented by the following general formula (5).

$$(1\text{-}m\text{-}n)D + mB + nE \qquad (5)$$

[In formula (5), m satisfies $0 \leq m < 0.1$ and n satisfies $0 \leq n \leq 0.01$, and D, B and E are complex oxides represented by the following general formula (6), the following general formula (3) and the following general formula (7), respectively.]

$$(Na_{1-x-y}K_xLi_y)_pNbO_3 \qquad (6)$$

[In formula (6), x satisfies $0.1 \leq x \leq 0.9$, y satisfies $0 \leq y \leq 0.1$, and p satisfies $0.95 \leq p \leq 1.05$.]

$$(M1)(M2)O_3 \qquad (3)$$

[In formula (3), M1 represents at least one element selected from the group consisting of Mg, Ca, Sr and Ba, and M2 represents at least one element selected from the group consisting of Ti, Zr and Hf.]

$$(M3)(Nb)_2O_6 \qquad (7)$$

[In formula (7), M3 represents at least one element selected from the group consisting of Mg, Ca, Sr and Ba.]

Since the composition described above has a high Curie temperature, the piezoelectric ceramic containing the composition as a major component has a sufficiently wide usable temperature range.

Also according to the invention, the piezoelectric ceramic preferably contains Mn and Cu at a total of 0.1-1.0 mass% in terms of MnO and CuO, with respect to the total composition. A piezoelectric ceramic containing Mn and Cu in this concentration range exhibits even more excellent piezoelectric characteristics.

According to the invention there is also provided a piezoelectric element comprising the aforementioned piezoelectric ceramic. Such a piezoelectric element, which comprises a piezoelectric ceramic having the characteristics described above, is environmentally friendly and exhibits satisfactorily excellent piezoelectric characteristics.

According to the invention it is possible to provide a piezoelectric ceramic with a sufficiently reduced lead content and with satisfactorily excellent piezoelectric characteristics, as well as a piezoelectric element comprising the piezoelectric ceramic.

## BRIEF DESCRIPTION OF THE DRAWINGS

Fig. 1 is a perspective view of an embodiment of a piezoelectric element of the invention.

Fig. 2 is a STEM (Scanning Transmission Electron Microscope) photograph showing an example of the microstructure of a piezoelectric ceramic according to the invention.

Fig. 3 is a set of charts showing the results of analysis of different points of the piezoelectric ceramic of Fig. 2 using an FE-STEM (Field Emission-Scanning Transmission Electron Microscope) and an Energy Dispersive X-ray Spectrometer (EDS).

Fig. 4 is a STEM (Scanning Transmission Electron Microscope) photograph showing another example of the microstructure of a piezoelectric ceramic according to the invention.

Fig. 5 is a pair of charts showing the results of analysis of different points of the piezoelectric ceramic of Fig. 3 using an FE-STEM and EDS.

Fig. 6 is a side view of another embodiment of a piezoelectric element of the invention.

Fig. 7 is a STEM (Scanning Transmission Electron Microscope) photograph showing an enlarged view of the area near a grain boundary of the piezoelectric ceramic 1 shown in Fig. 2.

Fig. 8 is a set of charts showing the results of analysis of different points of the piezoelectric ceramic of Fig. 7 using an FE-STEM and EDS.

Fig. 9 is a STEM (Scanning Transmission Electron Microscope) photograph showing an enlarged view of the area near a grain boundary of the piezoelectric ceramic shown in Fig. 4.

Fig. 10 is a set of charts showing the results of analysis of different points of the piezoelectric ceramic of Fig. 9 using an FE-STEM and EDS.

Fig. 11 is a STEM (Scanning Transmission Electron Microscope) photograph showing the microstructure of the piezoelectric ceramic of Comparative Example 1.

Fig. 12 is a set of charts showing the results of analysis of different points of the piezoelectric ceramic of Fig. 11 using an FE-STEM and EDS.

## DESCRIPTION OF THE PREFERRED EMBODIMENTS

Preferred embodiments of the invention will now be explained with reference to the accompanying drawings where necessary. Throughout the explanation of the drawings, identical or corresponding elements will be referred to

by like reference numerals and will be explained only once.

Fig. 1 is a perspective view of an embodiment of a piezoelectric element of the invention. The piezoelectric element 20 comprises a piezoelectric ceramic 1 and a pair of electrodes 2,3 formed on both surfaces thereof facing the piezoelectric ceramic 1.

The piezoelectric ceramic 1 is polarized in the direction of thickness, i.e. the direction in which the pair of electrodes 2,3 are facing, and application of a voltage between the electrodes 2,3 can produce longitudinal vibration in the thickness direction and vibration diffusing in the radial direction. The electrodes 2,3 are each composed of a metal such as gold (Au), for example. An external power source (not shown) may also be electrically connected to the electrodes 2,3 via a wire or the like.

The piezoelectric ceramic 1 contains as the major component a complex oxide with an alkali metal and niobium (Nb) as the constituent elements, and as accessory components, either or both a manganese (Mn) compound and copper (Cu) compound.

The complex oxide as the major component may be, for example, a complex oxide composed of a perovskite oxide such as sodium niobate ($NaNbO_3$), potassium niobate ($KNbO_3$) or lithium niobate ($LiNbO_3$), or a complex oxide obtained by replacing a portion of the Nb in a perovskite oxide with Ta. The complex oxide in the piezoelectric ceramic 1 may be a composition containing more than one of the aforementioned complex oxides, and a small amount of complex oxides such as $BaNb_2O_6$ or barium titanate ($BaTiO_3$) may also be dissolved in the complex oxide.

Examples for the major component of the piezoelectric ceramic 1 include compositions represented by the following general formula (8). The content of the major component (complex oxide composition) with respect to the total piezoelectric ceramic 1 is preferably at least 95 mass%, more preferably at least 97 mass% and even more preferably at least 99 mass% from the viewpoint of obtaining even more excellent piezoelectric characteristics.

$$(1-m-n)\ (Na_{1-x-y}K_xLi_y)_p\ (Nb_{1-z}Ta_z)O_3\ +\ m\ (M1)(M2)O_3\ +\ n(M3)(Nb_{1-w}Ta_w)_2O_6 \qquad (8)$$

In general formula (8), M1 is preferably at least one element selected from the group consisting of Mg, Ca, Sr and Ba, M2 is preferably at least one element selected from the group consisting of Ti, Zr and Hf, and M3 is preferably at least one element selected from the group consisting of Mg, Ca, Sr and Ba. In general formula (8) the oxygen composition is determined stoichiometrically, but an actual composition is permitted to deviate slightly from the stoichiometric composition (for example, to about 95-105 mol% based on the stoichiometric composition).

The value of x which represents the potassium content is preferably a numerical value satisfying $0.1 \leq x \leq 0.9$. If x is less than 0.1, it may not be possible to obtain a sufficiently large relative permittivity εr, electromechanical coupling coefficient kr and generated displacement. If x exceeds 0.9, on the other hand, volatilization of potassium during firing will be more severe, thus hampering the firing.

The value of y which represents the lithium content is preferably a numerical value satisfying $0 \leq y \leq 0.1$. If y exceeds than 0.1, it will tend to be difficult to obtain a sufficiently large relative permittivity εr, electromechanical coupling coefficient kr and generated displacement.

The values of z and w which represent the tantalum content are preferably numerical values satisfying $0 \leq z \leq 0.2$, $0 \leq w \leq 0.2$. If z and w exceed 0.2, the Curie temperature of the piezoelectric ceramic will tend to be lower and a sufficiently large electromechanical coupling coefficient kr and generated displacement may not be obtained.

In general formula (1), p is preferably a numerical value satisfying $0.95 \leq p \leq 1.05$. If p is less than 0.95, it will tend to be difficult to obtain a sufficiently large relative permittivity εr, electromechanical coupling coefficient kr and generated displacement. If p exceeds 1.05, on the other hand, the sintered density of the piezoelectric ceramic will be reduced, tending to interfere with polarization.

The value of m which represents the content of complex oxides represented by $(M1)(M2)O_3$ (the molar ratio in the composition of formula (8) above) preferably satisfies $0 \leq m < 0.1$ and more preferably $0 < m < 0.1$. The relative permittivity εr and generated displacement of the piezoelectric ceramic can be even further increased by including a complex oxide represented by $(M1)(M2)O_3$. However, if m is 0.1 or greater it will tend to be difficult to accomplish sintering of the piezoelectric ceramic.

The value of n which represents the content of complex oxides represented by $(M3)(Nb_{1-w}Ta_w)_2O_6$ (the molar ratio in the composition of formula (8) above) preferably satisfies $0 \leq n \leq 0.01$ and more preferably $0 < n \leq 0.01$. By including a complex oxide represented by $(M3)(Nb_{1-w}Ta_w)_2O_6$ it is possible to facilitate firing of the piezoelectric ceramic and to further increase the relative permittivity εr, electromechanical coupling coefficient kr and generated displacement of the obtained piezoelectric ceramic. If n exceeds 0.01, however, it may not be possible to obtain a sufficiently large

electromechanical coupling coefficient kr and generated displacement.

The piezoelectric ceramic 1 is made of a sintered compact composed mainly of the aforementioned complex oxides, for example. The piezoelectric ceramic 1 contains accessory components, namely Mn compounds and/or Cu compounds, segregated mainly at the grain boundary sections. The Mn compounds segregated at the grain boundaries may be Mn oxides such as MnO, and the Cu compounds may be Cu oxides such as CuO. The content of Mn compounds and Cu compounds as accessory components is preferably a total of 0.1-1.0 mass% and more preferably 0.2-1.0 mass% in terms of MnO and CuO with respect to the main component (complex oxide). At less than 0.1 mass%, it may not be possible to obtain a sufficient effect of improvement in the piezoelectric characteristics. At greater than 1.0 mass%, on the other hand, the Cu component and Mn component will infiltrate the complex oxide particles more readily, tending to prevent excellent piezoelectric characteristics.

The piezoelectric ceramic 1 may contain lead (Pb), but the content is preferably no greater than 1 mass%, and more preferably it contains absolutely no lead. A piezoelectric ceramic with a sufficiently reduced lead content will have reduced volatilization of lead during firing. In addition, it will release only a minimal amount of lead into the environment upon disposal after it has been distributed on the market as a piezoelectric part, such as a piezoelectric element. Such a piezoelectric ceramic 1 may be suitably used as a material for piezoelectric elements such as an oscillating element as an actuator, sounding body, and sensor.

Fig. 2 is a STEM (Scanning Transmission Electron Microscope) photograph showing an example of the microstructure of a piezoelectric ceramic according to the invention. The piezoelectric ceramic comprises as the major component a complex oxide containing an alkali metal and Nb as constituent elements, and Cu compound as an accessory component. Fig. 2 shows three complex oxide crystal grains and the grain boundaries formed by the crystal grains. The piezoelectric ceramic is composed of aggregates of the complex oxide crystal grains, as shown in Fig. 2. Ordinarily, an extremely thin layer known as the grain boundary layer is present at the boundary sections, i.e. grain boundaries, between crystal grains composing a sintered compact such as a piezoelectric ceramic.

Fig. 3 is a set of charts showing the results of analysis of different points of the piezoelectric ceramic of Fig. 2 using an FE-STEM (Field Emission-Scanning Transmission Electron Microscope) and an Energy Dispersive X-ray Spectrometer (EDS). Specifically, chart (A) in Fig. 3 shows the elements present at point A of the grain boundary layer (triple point). As seen in chart (A) of Fig. 3, point A of the grain boundary layer includes Mn element in addition to the constituent elements of the complex oxides as the main components of the piezoelectric ceramic. In the description throughout the present specification, a JEM-2100F (trade name) by JEOL Corp. was used as the FE-STEM and an energy dispersive X-ray spectrometer (EDS) connected to the FE-STEM was used for compositional analysis.

Chart (B) in Fig. 3 shows the FE-STEM and EDS analysis results for point B of the piezoelectric ceramic of Fig. 2, chart (C) in Fig. 3 shows the FE-STEM and EDS analysis results for point C of the piezoelectric ceramic of Fig. 2, and chart (D) in Fig. 3 shows the FE-STEM and EDS analysis results for point D of the piezoelectric ceramic of Fig. 2. That is, charts (B)-(D) in Fig. 3 show the elements present at points B-D of the grain boundary layer. As seen in charts (B)-(D) of Fig. 3, points B-D of the grain boundary layer includes Mn element in addition to the constituent elements of the complex oxide as the main components of the piezoelectric ceramic.

Chart (E) in Fig. 3 shows the FE-STEM (Field Emission Scanning Transmission Electron Microscope) analysis results for point E within the complex oxide crystal grains of the piezoelectric ceramic of Fig. 2. That is, chart (E) in Fig. 3 shows the elements present within the crystal grains. As seen in chart (E) of Fig. 3, the constituent elements of the complex oxides as the main components of the piezoelectric ceramic are present within the grains, but virtually no Mn element is present. Thus, the piezoelectric ceramic shown in Fig. 2 has a microstructure wherein Mn element is segregated at the grain boundaries. The Mn element is believed to be present in the form of Mn compounds such as oxides (MnO and the like), for example.

Fig. 4 is a STEM (Scanning Transmission Electron Microscope) photograph showing another example of the microstructure of a piezoelectric ceramic according to the invention. The piezoelectric ceramic comprises as the major component a complex oxide containing an alkali metal and Nb as constituent elements, and Cu compound as an accessory component. Fig. 4 shows two complex oxide crystal grains and the grain boundary formed by the crystal grains. This piezoelectric ceramic, like the piezoelectric ceramic of Fig. 2, is composed of aggregates of complex oxide crystal grains.

Fig. 5 is a pair of charts showing the results of analysis of different points of the piezoelectric ceramic of Fig. 4 using an FE-STEM and EDS. Chart (B') in Fig. 5 shows the FE-STEM and EDS analysis results for point B' of the piezoelectric ceramic of Fig. 4. That is, chart (B') in Fig. 5 show the elements present at point B' at the grain boundary layer. As seen in chart (B') of Fig. 5, point B' of the grain boundary layer includes Cu element in addition to the constituent elements of the complex oxides as the main components of the piezoelectric ceramic.

Chart (E') in Fig. 5 shows the FE-STEM (Field Emission Scanning Transmission Electron Microscope) analysis results for point E' within the complex oxide crystal grain of the piezoelectric ceramic of Fig. 4. That is, chart (E') in Fig. 5 shows the elements present within the crystal grains. As seen in chart (E') of Fig. 5, the constituent elements of the complex oxides as the main component of the piezoelectric ceramic are present within the grains, but virtually no Cu

element is present. Thus, the piezoelectric ceramic shown in Fig. 4 has a microstructure wherein Cu element is segregated at the grain boundaries.

Such segregation of Mn or Cu at the grain boundary layer cannot be analyzed with an X-ray microanalyzer (EPMA) that is usually used for compositional analysis. As mentioned above, analysis of the piezoelectric ceramic of the invention with an FE-STEM and EDS allows detection of Mn and/or Cu segregated at the grain boundaries or triple points.

The Mn compounds or Cu compounds in the piezoelectric ceramic are preferably segregated only at the grain boundaries, from the viewpoint of obtaining superior piezoelectric strain characteristics. However, a portion of the Mn compounds or Cu compounds may be penetrating into the complex oxide crystal grains. It is not preferred, however, for the Mn compounds or Cu compounds to be penetrating toward the interior, i.e. near the center, of the complex oxide crystal grains. This is because penetration of the Mn compounds or Cu compounds near the center may impair the excellent piezoelectric characteristics. Consequently, the regions for Mn compounds or Cu compounds to be present in the complex oxide crystal grains, as the major component, are preferably near the surfaces of the crystal grains (i.e. the grain boundaries). For example, they are preferably present in the regions within 10 nm from the surfaces of the crystal grains.

The Mn compounds or Cu compounds may also be segregated as grains, for example, in addition to being present at the grain boundary layers of the piezoelectric ceramic. However, the amount of Mn compounds or Cu compounds segregated as grains is preferably minimal, and more preferably none.

The element segregated at the grain boundaries of the piezoelectric ceramic of the invention is more preferably Mn than Cu. This is because segregation of Mn compounds at the grain boundaries can increase the resistance of the piezoelectric ceramic to a greater degree than segregation of Cu compounds at the grain boundaries. When Cu compound is added as an accessory component, however, firing can be accomplished at a lower temperature than with addition of Mn compounds.

A process for production of the piezoelectric element 20 shown in Fig. 1 will now be explained. First, oxide powders containing sodium, potassium, lithium, niobium, tantalum, zirconium, alkaline earth metals and titanium, for example, are prepared as starting materials for the complex oxide composition as the major component of the piezoelectric ceramic 1. An Mn oxide powder and Cu oxide powder, for example, are also prepared as starting materials for the accessory components of the piezoelectric ceramic 1. The starting materials used for the major component and accessory components of the piezoelectric ceramic 1 may be, instead of oxides, materials that form oxides upon firing, such as carbonic acid salts or oxalic acid salts.

Next, the starting materials are thoroughly dried and the starting materials for the main component are weighed out in proportions for the composition of general formula (8) above, for example. The starting materials for the Mn compounds and Cu compounds are weighed out so that the Mn compounds and Cu compounds are present at a total of 0.1-1.0 mass% in terms of MnO and CuO, respectively, against the total amount of complex oxides produced with the starting materials for the main component.

When a complex oxide represented by $(M1)(M2)O_3$ is to be included in the complex oxide represented by general formula (8), starting materials containing the elements M1 and M2, for example, are thoroughly mixed in an organic solvent or water using a ball mill or the like and then dried and fired at 1000°C-1300°C for 2-4 hours to prepare a complex oxide represented by $(M1)(M2)O_3$ (perovskite oxide). After preparing the complex oxides, these complex oxides, the starting materials for the complex oxides represented by $(Na_{1-x-y}K_xLi_y)_p(Nb_{1--z}Ta_z)O_3$ in general formula (8) above, the $(M3)(Nb_{1-w}Ta_w)_2O_6$ starting material and the starting materials for the accessory components are thoroughly mixed in an organic solvent or water using a ball mill or the like.

The mixture is then dried and press molded, and calcined at 750-1100°C for 1-4 hours. This yields a starting composition containing a composition that comprises multiple complex oxides represented by formula (8). The reason for mixing the starting materials for the other complex oxides after producing the complex oxide represented by $(M1)(M2)O_3$, which has an alkaline earth element and at least one element from among Ti, Zr and Hf as constituent elements, is as follows. If the starting material for the complex oxide represented by $(M1)(M2)O_3$ and the starting materials for the other complex oxides are mixed and then fired, the other complex oxides will react with the starting material for the complex oxide represented by $(M1)(M2)O_3$, making it impossible to obtain the target complex oxide.

The starting composition obtained by calcination is thoroughly pulverized in an organic solvent or water using a ball mill or the like and dried again, after which a binder is added and the mixture is granulated. Following granulation, the granulated powder is press molded using a uniaxial pressing machine or cold isostatic press (CIP) to obtain a compact. After heating the compact and removing the binder, the compact may then be fired at 1050-1350°C for 2-4 hours to obtain a sintered compact. The atmosphere for firing may be air or an atmosphere with adjusted nitrogen or oxygen partial pressure. By adjusting the firing temperature, firing time and atmosphere suitable for the major component composition, it is possible to segregate the added accessory components themselves, or the Mn compounds or Cu compounds produced from the accessory components, at the grain boundaries of the crystal grains of the major component.

The Mn compounds and Cu compounds to be segregated at the grain boundaries may be segregated at the grain boundaries of the sintered compact by adding Mn oxides or Cu oxides to the starting materials for the main component as described above, but they may also be segregated in a different manner. For example, a compact containing no Mn compound or Cu compound may be fired under suitable firing conditions in contact with Cu, Mn or a compound containing either or both of them, to accomplish segregation. Firing of the compact while in contact with Cu, Mn or a compound containing either or both of them diffuses the Cu or Mn in the sintered compact and can yield a sintered compact with the Cu compounds or Mn compound segregated at the grain boundaries. For example, if Cu or a Cu-based alloy is used in an internal electrode layer and fired under suitable conditions, it is possible to obtain a sintered compact in which the Cu compounds are segregated at the grain boundaries in each piezoelectric layer.

For segregation of the Cu element and Mn element at the grain boundaries of the crystal grains of the main component, it is preferred to lower the oxygen partial pressure of the firing atmosphere for the compact or to precisely control the firing temperature for the compact to a slightly low firing temperature. This will allow grain growth of the major component while segregating the Cu compounds or Mn compounds at the grain boundaries.

The obtained sintered compact is then worked, if necessary, to form a piezoelectric ceramic 1 and electrodes 2,3, and an electric field is applied in heated silicone oil for polarization treatment. This procedure can yield the piezoelectric ceramic 1 and piezoelectric element 20 shown in Fig. 1. The electrodes 2,3 can be formed by coating a paste of Ag (silver) or the like and then drying and firing.

Another embodiment of a piezoelectric element according to the invention will now be explained.

Fig. 6 is a side view of another embodiment of a piezoelectric element of the invention. The stacked piezoelectric element 10 shown in Fig. 6 which is a piezoelectric element in stacked form, comprises a cuboid laminated body 11 and a pair of terminal electrodes 17A, 17B formed on the edges facing the laminated body 11.

The laminated body 11 is composed of an element 14 obtained by alternating lamination of internal electrode layers (electrode layers) 13A, 13B via piezoelectric layers 12, and a pair of protective layers 15 and 16 formed sandwiching the element 14 from both edge faces (above and below in the drawing) in the lamination direction. In the element 14, the piezoelectric layers 12 and internal electrode layers 13A, 13B are alternately laminated.

The piezoelectric layers 12 are layers composed of a piezoelectric ceramic. The piezoelectric ceramic may be the same as the piezoelectric ceramic 1 in the piezoelectric element 20 described above.

The thickness of each piezoelectric layer 12 may be set as desired. The thickness may be 1-100 μm, for example.

The internal electrode layers 13A, 13B are formed parallel to each other. The internal electrode layer 13A is formed in such a manner that one end is exposed at the edge of the laminated body 11 on which the terminal electrode 17A has been formed. The internal electrode layer 13B is formed in such a manner that one end is exposed at the edge of the laminated body 11 on which the terminal electrode 17B has been formed. The internal electrode layer 13A and internal electrode 13B are situated so that their major sections are stacked in the direction of lamination. The active regions 18 of the piezoelectric layers 12 between the internal electrodes 13A, 13B are the active sections that expand (are displaced) in the direction of lamination when a voltage is applied to the internal electrodes 13A, 13B. The regions 19 that are not between the internal electrodes 13A, 13B are the inactive sections.

The material for the internal electrode layers 13A, 13B may be Pt, Au, Pd or Ag-Pd alloy for most cases, and it may also contain Cu. By using a Cu-containing material for the internal electrode layers 13A, 13B, it is possible to diffuse the Cu of the internal electrode layers 13A, 13B into the piezoelectric layer 12 during the firing described hereunder. This will allow segregation of the Cu compound at the grain boundaries of the piezoelectric ceramic composing the piezoelectric layer 12.

The protective layers 15,16 are composed of a ceramic, and are preferably layers composed of a piezoelectric ceramic. As piezoelectric ceramics for formation of the protective layers 15,16 there may be mentioned the same ones as for the piezoelectric layers 12. The piezoelectric ceramics composing the protective layers 15,16 and piezoelectric layers 12 may be the same or different.

The terminal electrodes 17A, 17B are in contact with the ends of the internal electrodes 13A, 13B exposed at the edge faces of the edges of the laminated body 11 on which they are formed. Electrical connection is thus established between the terminal electrodes 17A, 17B and the internal electrodes 13A, 13B. The terminal electrodes 17A, 17B may be composed of a conductive material consisting mainly of Ag, Au, Cu or the like. The thicknesses of the terminal electrodes 17A, 17B may be appropriately set according to the purpose of use and the size of the stacked piezoelectric element, and for example, they may be 10-50 μm.

A process for production of the stacked piezoelectric element 10 will now be explained. The piezoelectric layers 12 are composed of a piezoelectric ceramic. The piezoelectric ceramic contains as the major component a complex oxide with an alkali metal and niobium (Nb) as the constituent elements, and as accessory components, MnO or a copper compound such as CuO.

In the process for production of the stacked piezoelectric element 10, there are first prepared the starting materials, namely the compound for the piezoelectric ceramic used to form the piezoelectric layer 12, and other added components. Specifically, oxide powders containing sodium, potassium, lithium, niobium, tantalum, zirconium, alkaline

earth metal elements and titanium, for example, are prepared as starting materials for the complex oxide as the main component of the piezoelectric ceramic used to form the piezoelectric layer 12. The starting materials used for the major component may be, instead of oxides, materials that form oxides upon firing, such as carbonic acid salts or oxalic acid salts. In this case it is assumed that no Cu-containing starting material is used.

Next, the starting materials for the complex oxide are thoroughly dried and the starting materials for the main component are weighed out in proportions for the composition of general formula (8) above, for example.

When a complex oxide represented by $(M1)(M2)O_3$ is to be included in the complex oxide represented by general formula (8), starting materials for the elements M1 and M2 for example, may be thoroughly mixed in an organic solvent or water using a ball mill or the like and then dried and fired at 1000°C-1300°C for 2-4 hours to prepare a complex oxide represented by $(M1)(M2)O_3$ (perovskite oxide). After preparing the complex oxides, these complex oxides, the starting materials for the complex oxides represented by $(Na_{1-x-y}K_xLi_y)_p(Nb_{1-z}Ta_z)O_3$ in general formula (8) above and the $(M3)(Nb_{1-w}Ta_w)_2O_6$ starting material are thoroughly mixed in an organic solvent or water using a ball mill or the like.

The mixture is then dried and calcined by, for example, heat treatment at a temperature of 750-1100°C for 1-4 hours. This yields a piezoelectric ceramic starting composition comprising a complex oxide containing Nb element and alkali metal elements as constituent elements, and containing no lead.

The starting composition is then subjected to wet grinding with a ball mill or the like and dried to obtain a starting composition powder. Next, an organic binder, organic solvent, organic plasticizer and the like are added to the starting composition powder and mixed for about 20 hours using a ball mill or the like, to obtain a piezoelectric paste.

The piezoelectric paste is coated onto a polyethylene terephthalate (PET) base film by doctor blading, for example, to obtain a piezoelectric green sheet for formation of the piezoelectric layers 12. The piezoelectric green sheet comprises mainly the piezoelectric material starting composition and a binder.

The piezoelectric green sheet is then coated with an electrode paste for formation of the internal electrodes 13A, 13B by a screen printing method or the like, to form an electrode paste layer composed of the electrode paste. A lamination sheet is thus obtained comprising the electrode paste layer on the piezoelectric green sheet. The electrode paste layer is formed into a pattern to obtain the shapes of the aforementioned internal electrodes 13A and 13B.

The electrode paste used to form the electrode paste layer contains a metal such as Pt, Au, Pd, Ag-Pd alloy or Cu or a Cu-containing compound (alloy), a binder and an organic solvent. The binder and organic solvent may be publicly known ones. The total content of the metal in the electrode paste is preferably at least 40 mass% and more preferably 50-60 mass%.

Several laminating sheets are then stacked in such a manner that the electrode paste layers and piezoelectric green sheets are alternately situated, and several piezoelectric green sheet layers are further laminated onto the surface of both edge faces in the direction of lamination of the laminated structure. The laminated body obtained in this manner is pressed in the direction of lamination while heating appropriately, and is cut to the desired size if necessary, to obtain a green laminated body (laminated body).

The green laminated body is then set on a stabilized zirconia setter or the like and heated in an air atmosphere for degreasing treatment to remove the binder or organic solvent in the piezoelectric green sheet and electrode paste layer.

Next, the green laminated body from which the binder has been removed is subjected to firing treatment (main firing) by heating in a sealed container (air atmosphere), at 1100-1150°C for 2-4 hours, for example, to obtain a laminated body 11. The piezoelectric green sheet and electrode paste layer are integrally fired in this main firing treatment, the internal electrodes 13A, 13B are formed from the electrode paste layer, and the piezoelectric layers 12 are formed from the piezoelectric green sheet sandwiched between the internal electrodes 13A, 13B. Also, the protective layers 15,16 are formed from the laminated piezoelectric green sheet on both edge faces in the direction of lamination of the green laminated body. When Cu or a Cu-containing compound (alloy) is used in the internal electrode, the Cu component diffuses from the internal electrodes 13A, 13B into the piezoelectric layer 12 during firing. This also allows segregation of the Cu compound at the grain boundaries of the piezoelectric ceramic composing the piezoelectric layer 12. In this case, the firing temperature or firing time and atmosphere may be adjusted to modify the amount of Cu component that diffuses from the internal electrode. The firing conditions may be appropriately adjusted depending on the composition of the complex oxides used to form the piezoelectric layer 12.

The terminal electrodes 17A, 17B are then baked onto the mutually opposing edge faces that are parallel in the direction of lamination of the obtained laminated body 11 (the edge faces where the internal electrode 13A, 13B terminals are exposed). Specifically, a terminal electrode-forming paste containing the metal for the terminal electrodes 17A, 17B, the organic binder and other components is coated onto the aforementioned edge faces of the laminated body 11 and then fired to form the terminal electrodes 17A, 17B. This produces a stacked piezoelectric element 10 having the structure shown in Fig. 6. The terminal electrodes 17A, 17B can also be formed by a method such as sputtering, vapor deposition, electroless plating or the like, instead of the baking method described above.

Also, the stacked piezoelectric element 10 may be subjected to polarization treatment wherein a voltage is applied between the terminal electrodes 17A, 17B for about 10 minutes to an electric field strength of about 2-5 kV/mm in an environment of 120°C, to obtain a stacked piezoelectric element 10 that functions as a piezoelectric actuator.

The embodiment described above is only a preferred embodiment of the invention, and the invention is in no way limited thereto. For example, the main component of the piezoelectric ceramic 1 was described as a composition composed of several different complex oxides for this embodiment, but the main component may instead be a single type of complex oxide, i.e., the constituent element may consist only of a complex oxide containing an alkali metal and Nb.

[Examples]

The present invention will now be explained in greater detail based on examples and comparative examples, with the understanding that these examples are in no way limitative on the invention.
(Example 1)

{Fabrication of piezoelectric element}

A piezoelectric element 20 such as shown in Fig. 1 was fabricated by the following procedure. First, sodium carbonate ($Na_2CO_3$) powder, potassium carbonate ($K_2CO_3$) powder, lithium carbonate ($Li_2CO_3$) powder, niobium oxide ($Nb_2O_5$) powder, tantalum oxide ($Ta_2O_5$) powder, strontium carbonate ($SrCO_3$) powder, zirconium oxide ($ZrO_2$) powder and barium carbonate ($BaCO_3$) powder were prepared. Manganese carbonate ($MnCO_3$) powder was also prepared as the starting material for the accessory component. After thoroughly drying the starting materials, they were weighed out so that the composition (molar ratio) of the complex oxide as the major component of the piezoelectric ceramic conformed to the following formula (9).
$$0.945(Na_{0.57}K_{0.38}Li_{0.05})(Nb_{0.9}Ta_{0.1})O_3 + 0.05SrZrO_3 + 0.005Ba(Nb_{0.9}Ta_{0.1})_2O_6 \quad (9)$$

The $MnCO_3$ powder was also weighed out to 0.5 mass% in terms of MnO, based on the total complex oxide composition of formula (9) above.
The strontium carbonate ($SrCO_3$) powder and zirconium oxide ($ZrO_2$) powder weighed out in the manner described above were thoroughly mixed in water using a ball mill and then dried and fired at 1000-1300°C for 2-4 hours to prepare a perovskite oxide (complex oxide) represented by $SrZrO_3$.
The perovskite oxide and the sodium carbonate ($Na_2CO_3$) powder, potassium carbonate ($K_2CO_3$) powder, lithium carbonate ($Li_2CO_3$) powder, niobium oxide ($Nb_2O_5$) powder, tantalum oxide ($Ta_2O_5$) powder and manganese carbonate ($MnCO_3$) powder weighed out in the manner described above were thoroughly mixed in ethanol using a ball mill and then dried and press molded, and calcined at 750-1100°C for 1-4 hours.
After calcining of the mixture, the calcined product was thoroughly pulverized in ethanol using a ball mill and dried again, after which a binder (PVA) solution was added and the mixture was granulated. The obtained granulated powder was press molded using a uniaxial pressing machine to obtain a compact. The compact was then heated to 600°C for binder removal, and fired at 1120°C for 2 hours in an air atmosphere to obtain a sintered compact.
The obtained sintered compact was coated with a conductive paste, dried and fired to form electrodes 2,3. Next, an electric field was applied in heated silicone oil for polarization treatment to obtain a piezoelectric element 20 comprising a piezoelectric ceramic 1.
{Observation of microstructure and compositional analysis}
Observation of the microstructure and compositional analysis of the obtained piezoelectric ceramic 1 were accomplished using a STEM-EDS. Fig. 2 is a STEM (Scanning Transmission Electron Microscope) photograph showing the microstructure of the piezoelectric ceramic 1 of Example 1. Fig. 7 is a STEM (Scanning Transmission Electron Microscope) photograph showing an enlarged view of the area near a grain boundary of the piezoelectric ceramic 1 shown in Fig. 2.
Fig. 8 is a chart showing the results of analysis of different points of the piezoelectric ceramic of Fig. 7 using an FE-STEM and EDS. Chart (F) in Fig. 8 shows the FE-STEM and EDS analysis results for point F of the piezoelectric ceramic of Fig. 7. That is, chart (F) in Fig. 8 show the elements present at point F at the grain boundary layer. As seen in chart (F) of Fig. 8, Mn element was detected at point F of the grain boundary layer in addition to the constituent elements of the complex oxide as the main component of the piezoelectric ceramic. The peak intensity for Mn element and Nb element was 0.15 as the proportion in terms of MnO and $Nb_2O_5$ ($MnO/Nb_2O_5$).
Chart (G) in Fig. 8 shows the FE-STEM and EDS analysis results for point G of the piezoelectric ceramic of Fig. 7. That is, chart (G) in Fig. 8 shows the elements present at point G within the complex oxide crystal grains, located at a position 5 nm from the grain boundary. As seen in chart (G) of Fig. 8, a trace amount of Mn element was detected

at point G within the grains, in addition to the constituent elements of the complex oxides as the main components of the piezoelectric ceramic. The peak intensity for Mn element and Nb element was 0.01 as the peak proportion in terms of MnO and $Nb_2O_5$ ($MnO/Nb_2O_5$).

Chart (H) in Fig. 8 shows the FE-STEM and EDS analysis results for point H of the piezoelectric ceramic of Fig. 6. That is, chart (H) in Fig. 8 shows the elements present at point H within the complex oxide crystal grains, located at a position 10 nm from the grain boundary. As seen in chart (H) of Fig. 8, a trace amount of Mn element was detected at point H within the grains, in addition to the constituent elements of the complex oxides as the main components of the piezoelectric ceramic. The peak intensity for Mn element and Nb element was 0.01 as the proportion in terms of MnO and $Nb_2O_5$ ($MnO/Nb_2O_5$).

Based on the results of compositional analysis shown in charts (F), (G) and (H) of Fig. 8, it was confirmed that virtually no Mn was present within the complex oxide grains, and therefore it was segregated near the grain boundaries of the piezoelectric ceramic 1.

{Evaluation of piezoelectric characteristics}

The obtained piezoelectric element 20 was allowed to stand for 24 hours prior to measurement of the resistivity and the relative permittivity εr and piezoelectric d constant ($d_{33}$) as the piezoelectric characteristics. The resistivity was measured using a digital ultra high resistance meter (trade name: R8340A by Advantest). The relative permittivity εr was measured at a frequency of 1 kHz using an impedance analyzer (trade name: HP4294A by Agilent Technologies). The piezoelectric d constant ($d_{33}$) was measured using a $d_{33}$ meter (trade name: ZJ-4B by Institute of Acoustics Academia Sinica). The measurement results are shown in Table 1.

(Examples 2-4)

Piezoelectric elements were fabricated and their piezoelectric characteristics evaluated in the same manner as Example 1, except that the $MnCO_3$ powder was added in an amount so that the mass ratio in terms of MnO with respect to the total complex oxide composition of formula (9) above was as listed in Table 1. The evaluation results are shown in Table 1.

(Example 5)

{Fabrication of piezoelectric element}

A piezoelectric element was fabricated in the same manner as Example 1, except that $Cu_2O$ powder was prepared instead of $MnCO_3$ powder, and the $Cu_2O$ powder was mixed so that the mass ratio with respect to the total complex oxide composition of formula (9) above was 1.0 mass% in terms of CuO.

{Observation of microstructure and compositional analysis}

Observation of the microstructure and compositional analysis of the obtained piezoelectric ceramic were accomplished using an STEM-EDS, in the same manner as Example 1. Fig. 4 is a STEM (Scanning Transmission Electron Microscope) photograph showing the microstructure of the piezoelectric ceramic of Example 5. Fig. 9 is a STEM (Scanning Transmission Electron Microscope) photograph showing an enlarged view of the area near a grain boundary of the piezoelectric ceramic shown in Fig. 4.

Fig. 10 is a chart showing the results of analysis of different points of the piezoelectric ceramic of Fig. 9 using an FE-STEM and EDS.

Chart (I) in Fig. 10 shows the FE-STEM and EDS analysis results for point I of the piezoelectric ceramic of Fig. 9. That is, chart (I) in Fig. 10 show the elements present at point I at the grain boundary layer. As seen in chart (I) of Fig. 10, Cu element was detected at point I of the grain boundary layer in addition to the constituent elements of the complex oxides as the main components of the piezoelectric ceramic. The peak intensity for Cu element and Nb element was 0.32 as the proportion in terms of CuO and $Nb_2O_5$ ($CuO/Nb_2O_5$).

Chart (J) in Fig. 10 shows the FE-STEM and EDS analysis results for point J of the piezoelectric ceramic of Fig. 9. That is, chart (J) in Fig. 10 shows the elements present at point J within the complex oxide crystal grains, located at a position 5 nm from the grain boundary. As seen in chart (J) of Fig. 10, at point J within the grains there were detected the constituent elements of the complex oxides as the main components of the piezoelectric ceramic, but no Cu element was detected. Therefore, the peak intensity for Cu element and Nb element was 0.00 as the proportion in terms of CuO and $Nb_2O_5$ ($CuO/Nb_2O_5$).

Chart (K) in Fig. 10 shows the FE-STEM and EDS analysis results for point K of the piezoelectric ceramic of Fig. 7. That is, chart (K) in Fig. 10 shows the elements present at point K within the complex oxide crystal grains, located at a position 10 nm from the grain boundary. As seen in chart (K) of Fig. 10, at point K within the grains there were detected the constituent elements of the complex oxides as the main components of the piezoelectric ceramic, but no Cu element was detected. Therefore, the peak intensity for Cu element and Nb element was 0.00 as the proportion in terms of CuO and $Nb_2O_5$ ($CuO/Nb_2O_5$).

Based on the results of compositional analysis shown in charts (I), (J) and (K) of Fig. 10 it was confirmed that no Cu was present within the complex oxide crystal grains, and that it was segregated at the grain boundaries of the complex oxide crystal grains.

{Evaluation of piezoelectric characteristics}
The piezoelectric characteristics were evaluated in the same manner as Example 1. The results are shown in Table 1.
(Examples 6-8)
Piezoelectric elements were fabricated and their piezoelectric characteristics evaluated in the same manner as Example 1 except that the $Cu_2O$ powder was added so that the mass ratio in terms of CuO with respect to the total complex oxide composition of formula (9) above was as listed in Table 1. The evaluation results are shown in Table 1.
(Comparative Example 1)
A piezoelectric element was fabricated in the same manner as Example 1, except that the firing temperature of the compact was 1135°C, or 15°C higher than in Example 1.
{Observation of microstructure and compositional analysis}
Observation of the microstructure and compositional analysis of the obtained piezoelectric ceramic were accomplished using an STEM-EDS and EDS, in the same manner as Example 1. Fig. 11 is a STEM (Scanning Transmission Electron Microscope) photograph showing the microstructure of the piezoelectric ceramic of Comparative Example 1.
Fig. 12 is a chart showing the results of analysis of different points of the piezoelectric ceramic of Fig. 11 using an FE-STEM and EDS.
Chart (L) in Fig. 12 shows the FE-STEM and EDS analysis results for point L of the piezoelectric ceramic of Fig. 11. That is, chart (L) in Fig. 12 show the elements present at point L at the grain boundary layer. As seen in chart (L) of Fig. 12, a trace amount of Mn element was detected at point L at the grain boundary, in addition to the constituent elements of the complex oxide as the main components of the piezoelectric ceramic. The peak intensity for Mn element and Nb element was 0.03 as the proportion in terms of MnO and $Nb_2O_5$ ($MnO/Nb_2O_5$).
Chart (M) in Fig. 12 shows the FE-STEM and EDS analysis results for point M of the piezoelectric ceramic of Fig. 11. That is, chart (M) in Fig. 12 shows the elements present at point M within the complex oxide crystal grains, located at a position 5 nm from the grain boundary. As seen in chart (M) of Fig. 12, a trace amount of Mn element was detected at point M within the grains, in addition to the constituent elements of the complex oxide as the main components of the piezoelectric ceramic. The peak intensity for Mn element and Nb element was 0.02 as the proportion in terms of MnO and $Nb_2O_5$ ($MnO/Nb_2O_5$).
Chart (N) in Fig. 12 shows the FE-STEM and EDS analysis results for each point of the piezoelectric ceramic of Fig. 11. That is, chart (N) in Fig. 12 shows the elements present at point N within the complex oxide crystal grains, located at a position 10 nm from the grain boundary. As seen in chart (N) of Fig. 12, a trace amount of Mn element was detected at point N within the grains, in addition to the constituent elements of the complex oxide as the main components of the piezoelectric ceramic. The peak intensity for Mn element and Nb element was 0.01 as the proportion in terms of MnO and $Nb_2O_5$ ($MnO/Nb_2O_5$).
Based on the results of compositional analysis shown in charts (L), (M) and (N) of Fig. 12, Mn was present at the grain boundaries and within crystal grains of the complex oxide, with no observable segregation.
{Evaluation of piezoelectric characteristics}
The piezoelectric characteristics were evaluated in the same manner as Example 1. The results are shown in Table 1.
[Table 1]

| | $MnCO_3$ addition (mass%) | $Cu_2O$ addition (mass%) | Resistivity (Ω·cm) | Relative permittivity εr | $d_{33}$ (pC/N) |
|---|---|---|---|---|---|
| Example 1 | 0.5 | - | $2.7\times10^{12}$ | 1630 | 320 |
| Example 2 | 0.1 | - | $8.6\times10^{11}$ | 1493 | 289 |
| Example 3 | 0.2 | - | $2.9\times10^{12}$ | 1572 | 307 |
| Example 4 | 1.0 | - | $2.1\times10^{12}$ | 1519 | 296 |
| Example 5 | - | 1.0 | $6.9\times10^{11}$ | 1586 | 301 |
| Example 6 | - | 0.1 | $2.6\times10^{11}$ | 1460 | 274 |
| Example 7 | - | 0.2 | $6.2\times10^{11}$ | 1452 | 288 |
| Example 8 | - | 0.5 | $8.8\times10^{11}$ | 1591 | 310 |

(continued)

| | $MnCO_3$ addition (mass%) | $Cu_2O$ addition (mass%) | Resistivity (Ω·cm) | Relative permittivity εr | $d_{33}$ (pC/N) |
|---|---|---|---|---|---|
| Comp. Example 1 | 0.5 | - | $3.4\times10^9$ | 1316 | 197 |
| Note 1: The amounts of $MnCO_3$ addition and $Cu_2O$ addition represent the mass proportions (mass%) in terms of MnO and CuO, with respect to the total complex oxide mass. | | | | | |

## Claims

**1.** A piezoelectric ceramic having as the major component a composition consisting of one or more complex oxides containing metal elements different from lead as constituent elements, wherein
at least one of the complex oxides contains an alkali metal and Nb as constituent elements, and
either or both the Mn and Cu are segregated at the grain boundaries of the composition.

**2.** A piezoelectric ceramic according to claim 1, wherein
the composition is represented by the following general formula (1):

$$(1\text{-}m\text{-}n)A + mB + nC \qquad (1)$$

[In formula (1), m satisfies $0 \le m < 0.1$ and n satisfies $0 \le n \le 0.01$], and
A, B and C are complex oxides represented by the following general formula (2), the following general formula (3) and the following general formula (4), respectively,
and the total content of Ta in the complex oxides represented by the following general formula (2) and the complex oxides represented by the following general formula (4) is no greater than 20 mol% with respect to the total composition.

$$(Na_{1-x-y}K_xLi_y)_p(Nb_{1-z}Ta_z)O_3 \qquad (2)$$

[In formula (2), x satisfies $0.1 \le x \le 0.9$, y satisfies $0 \le y \le 0.1$, z satisfies $0 \le z \le 0.2$ and p satisfies $0.95 \le p \le 1.05$.]

$$(M1)(M2)O_3 \qquad (3)$$

[In formula (3), M1 represents at least one element selected from the group consisting of Mg, Ca, Sr and Ba, and M2 represents at least one element selected from the group consisting of Ti, Zr and Hf.]

$$(M3)(Nb_{1-w}Ta_w)_2O_6 \qquad (4)$$

[In formula (4), M3 represents at least one element selected from the group consisting of Mg, Ca, Sr and Ba, and w satisfies $0 \le w \le 0.2$.]

**3.** A piezoelectric ceramic according to claim 1 wherein
the composition is represented by the following general formula (5):

$$(1\text{-}m\text{-}n)D + mB + nE \qquad (5)$$

[In formula (5), m satisfies $0 \leq m < 0.1$ and n satisfies $0 \leq n \leq 0.01$], and
D, B and E are complex oxides represented by the following general formula (6), the following general formula (3) and the following general formula (7), respectively.

$$(Na_{1-x-y}K_xLi_y)_pNbO_3 \qquad (6)$$

[In formula (6), x satisfies $0.1 \leq x \leq 0.9$, y satisfies $0 \leq y \leq 0.1$, and p satisfies $0.95 \leq p \leq 1.05$.]

$$(M1)(M2)O_3 \qquad (3)$$

[In formula (3), M1 represents at least one element selected from the group consisting of Mg, Ca, Sr and Ba, and M2 represents at least one element selected from the group consisting of Ti, Zr and Hf.]

$$(M3)Nb_2O_6 \qquad (7)$$

[In formula (7), M3 represents at least one element selected from the group consisting of Mg, Ca, Sr and Ba.]

**4.** A piezoelectric ceramic according to any one of claims 1 to 3, which comprises Mn and Cu in a total of 0.1-1.0 mass% in terms of MnO and CuO, with respect to the total composition.

**5.** A piezoelectric element comprising a piezoelectric ceramic according to any one of claims 1 to 4.

Fig.1

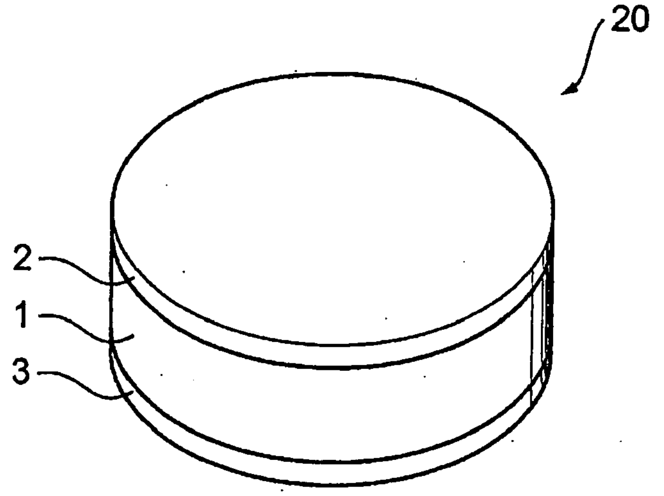

*Fig.2*

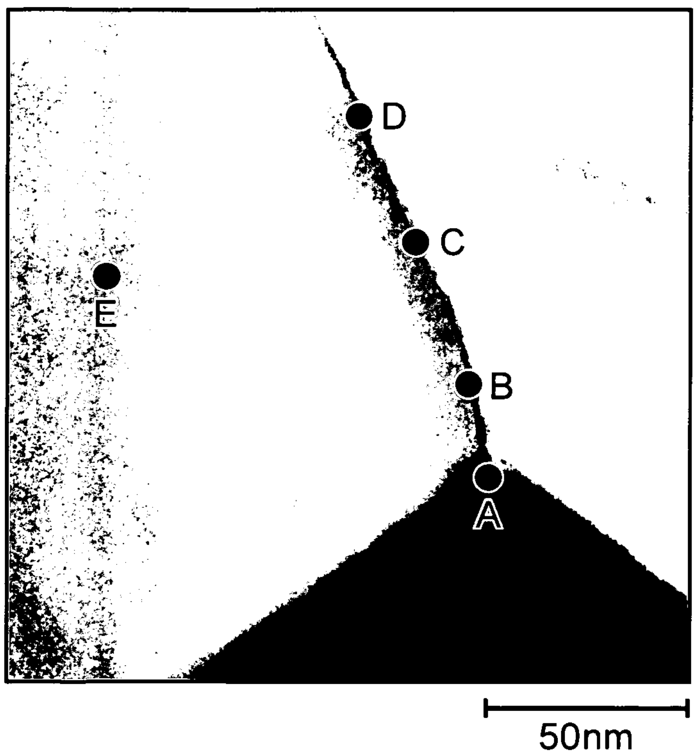

# Fig.3

(A)

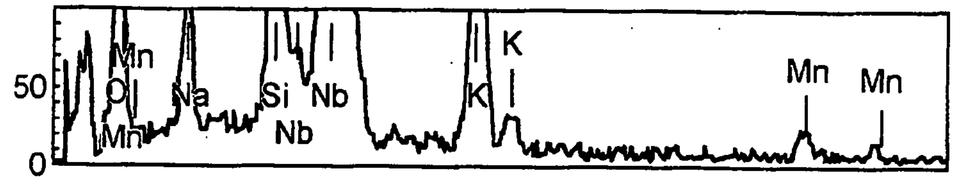
50
0
Mn
O
Mn
Na
Si
Nb
Nb
K
K
Mn
Mn

(B)

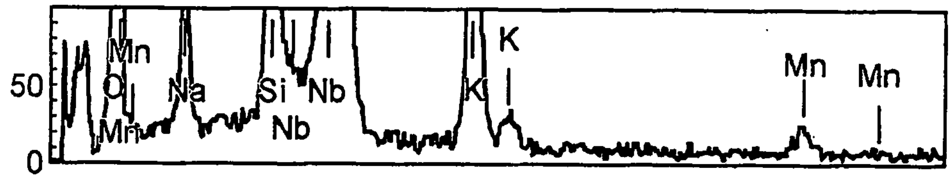
50
0
Mn
O
Mn
Na
Si
Nb
Nb
K
K
Mn
Mn

(C)

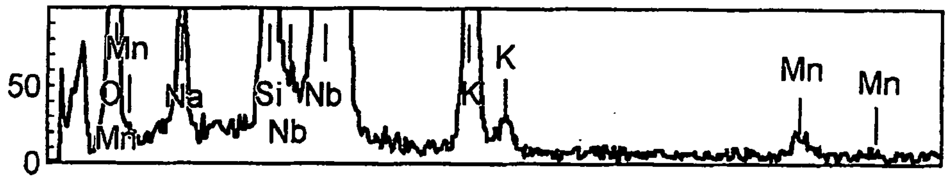
50
0
Mn
O
Mn
Na
Si
Nb
Nb
K
K
Mn
Mn

(D)

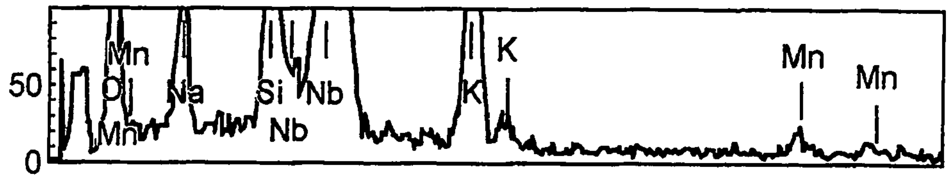
50
0
Mn
O
Mn
Na
Si
Nb
Nb
K
K
Mn
Mn

(E)

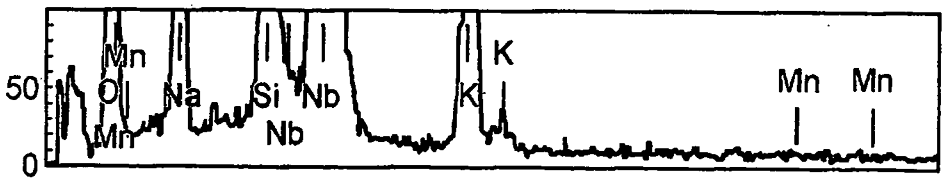
50
0
Mn
O
Mn
Na
Si
Nb
Nb
K
K
Mn
Mn

*Fig.4*

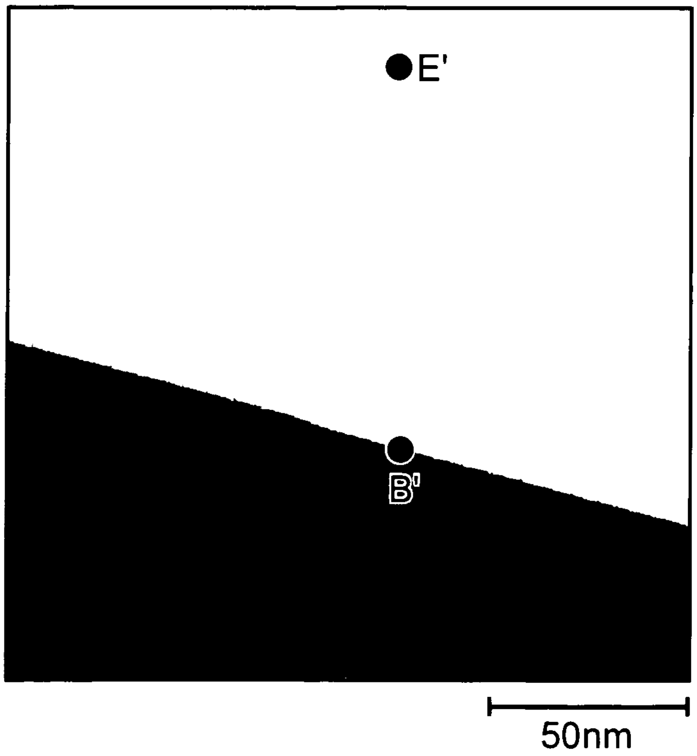

*Fig.5*

(B')

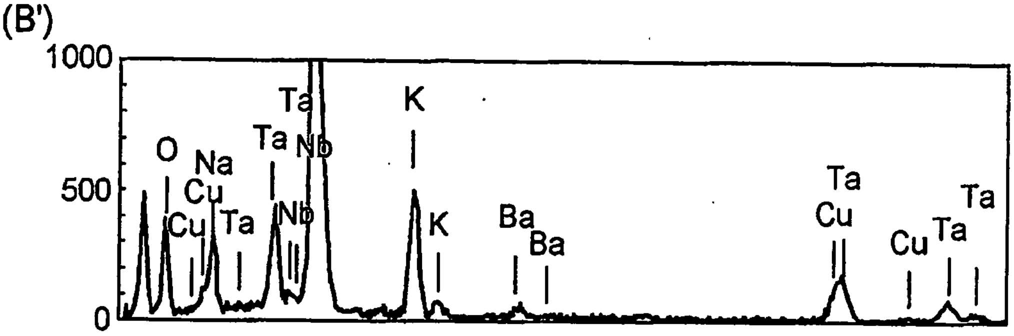


(E')

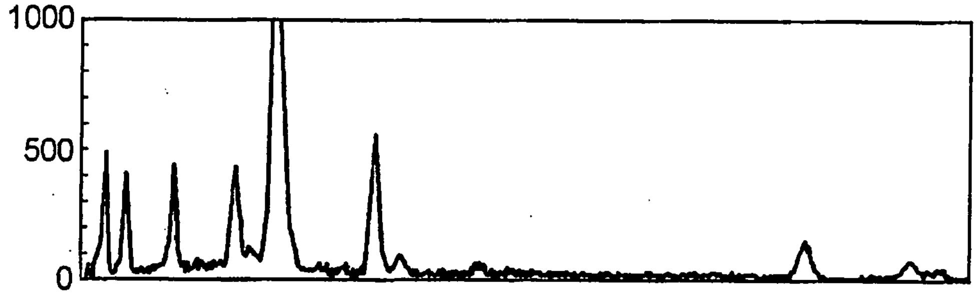

Fig.6

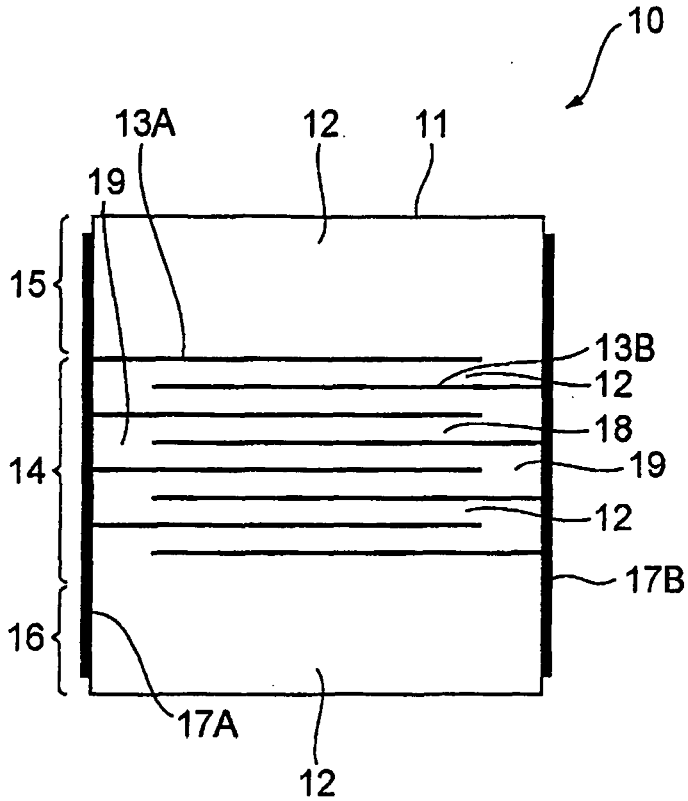

Fig.7

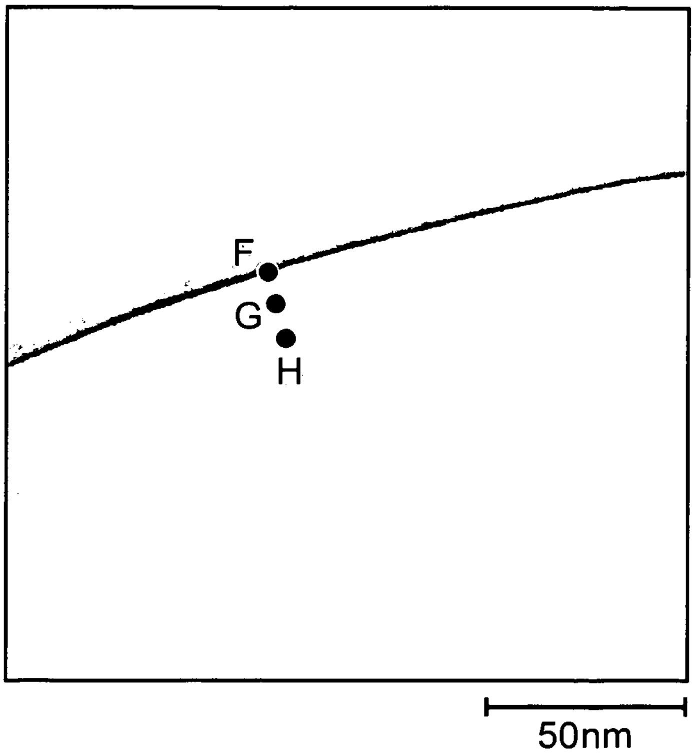

*Fig.8*

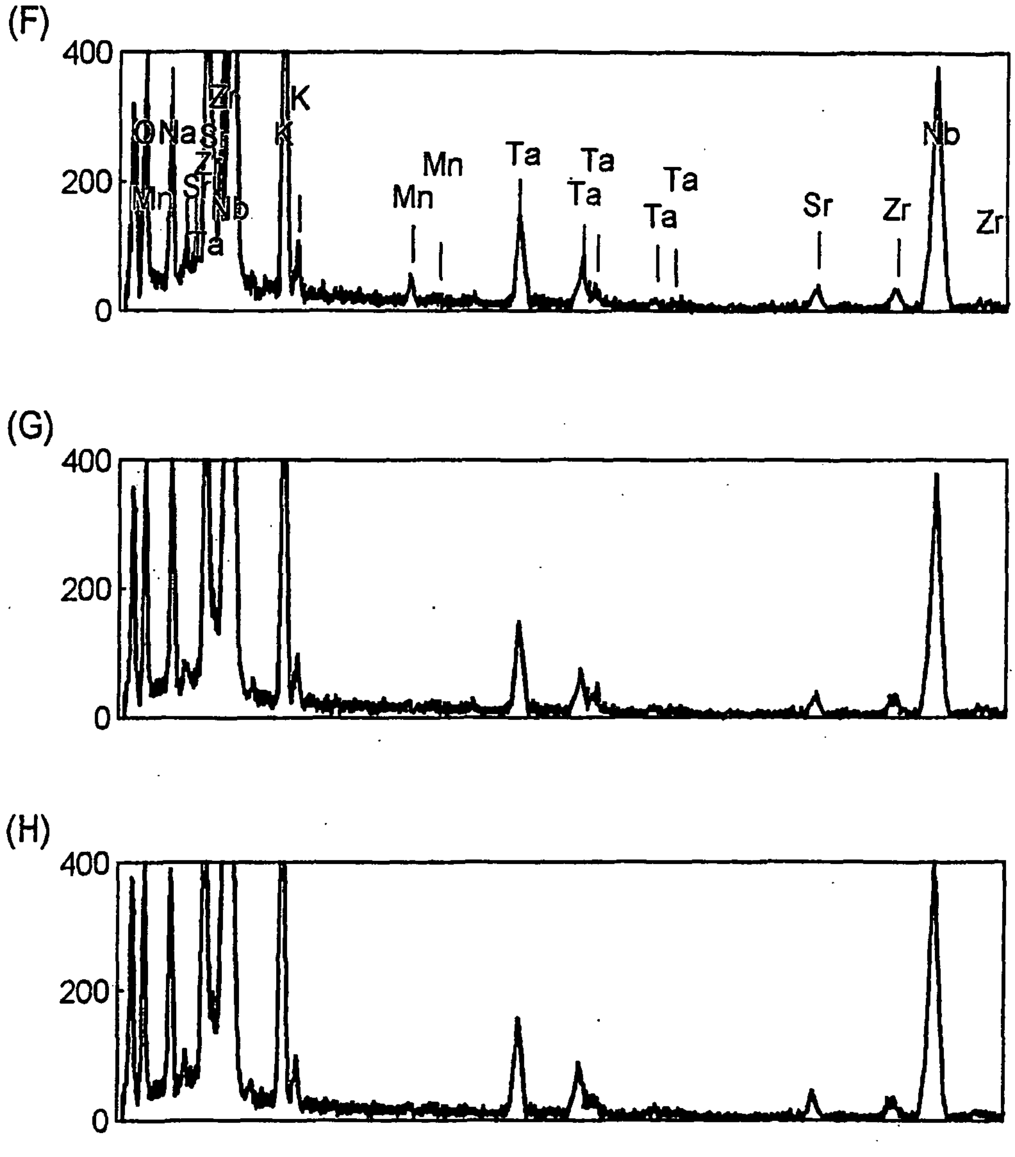
(F)
400
200
0
O
Na
Mn
Sr
Zr
Si
Ta
Nb
K
Mn
Ta
Sr
Zr
Nb
(G)
400
200
0
(H)
400
200
0

*Fig.9*

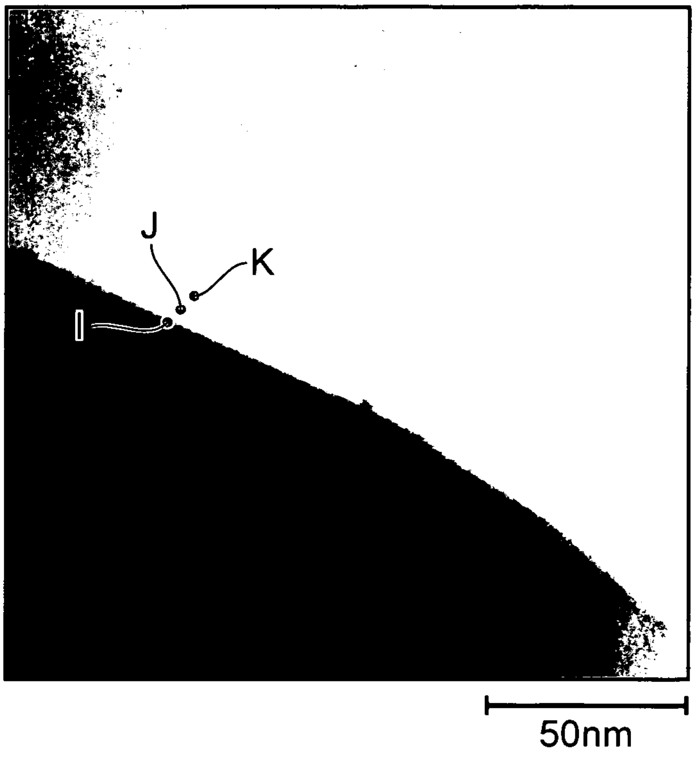

# Fig.10

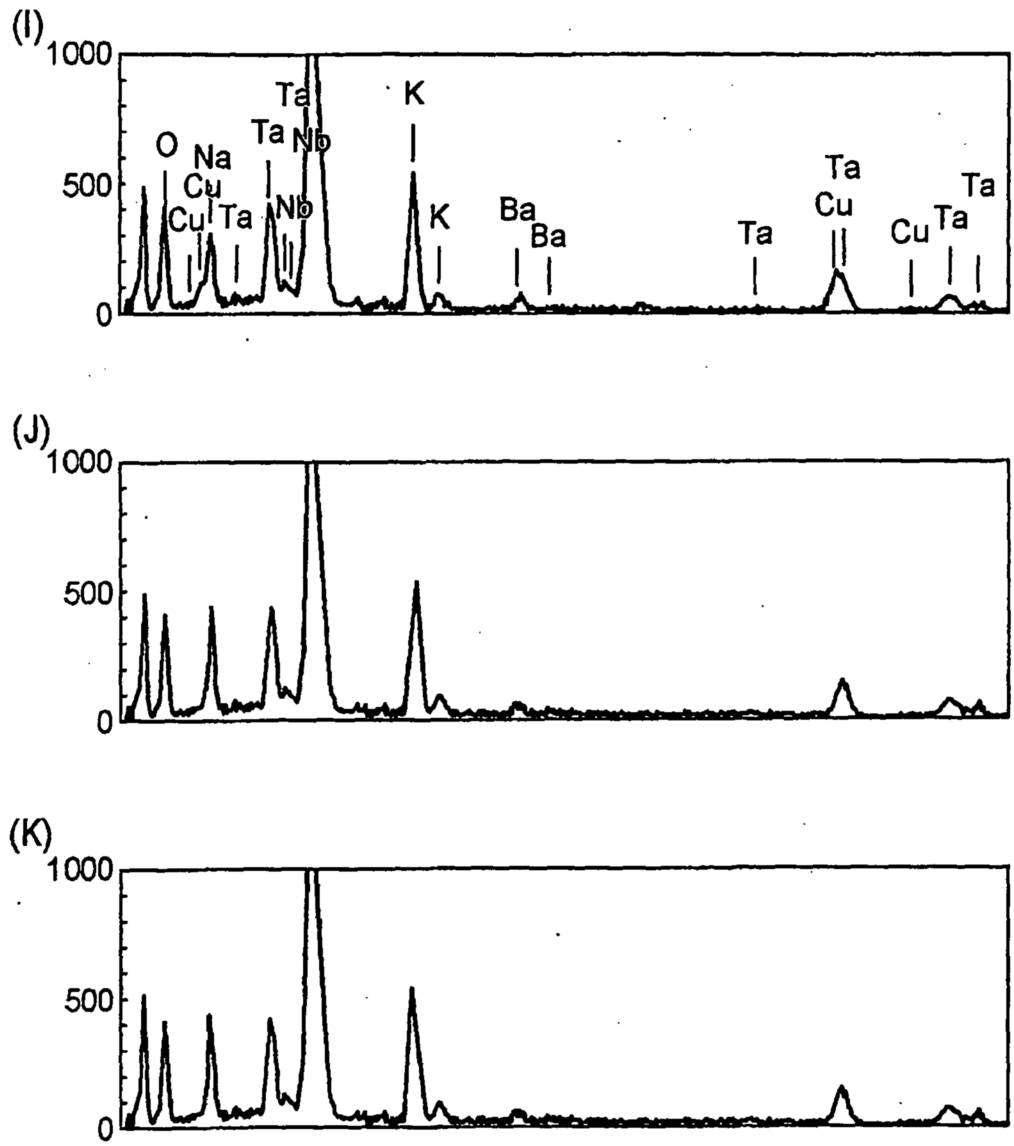
(I)
1000
500
0
O
Na
Cu
Cu
Ta
Ta
Ta
Nb
Nb
K
K
Ba
Ba
Ta
Ta
Cu
Cu
Ta
Ta
(J)
1000
500
0
(K)
1000
500
0

*Fig.11*

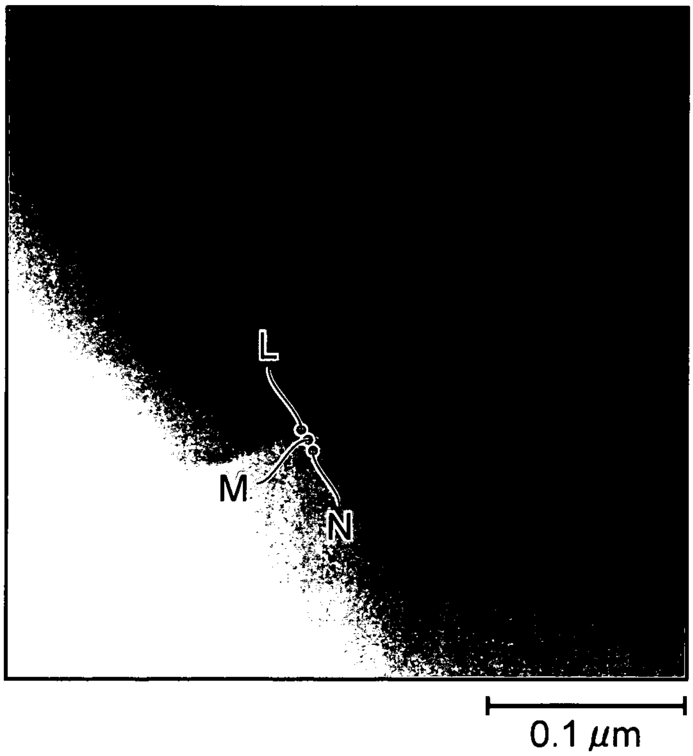

*Fig.12*

(L)

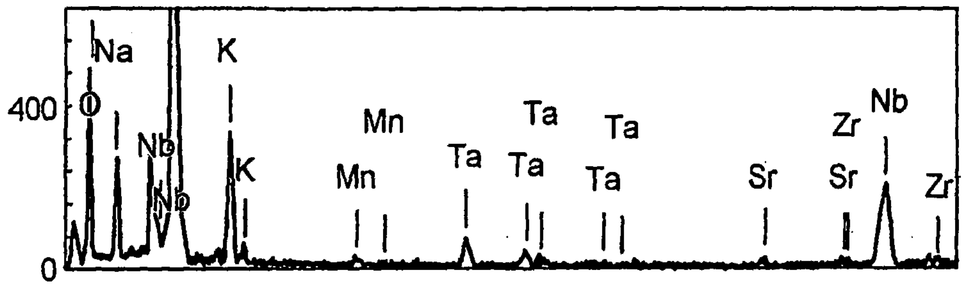


(M)

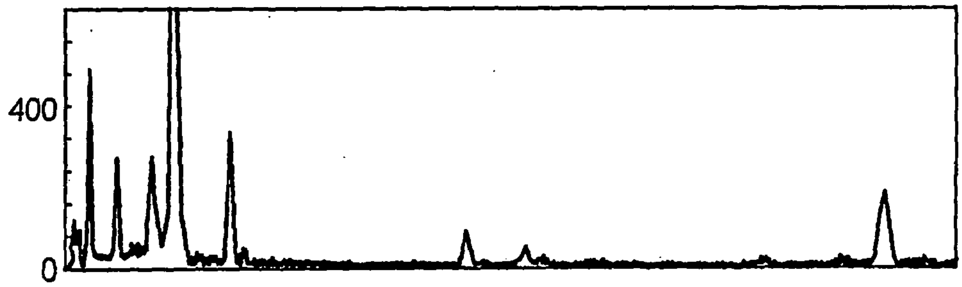


(N)

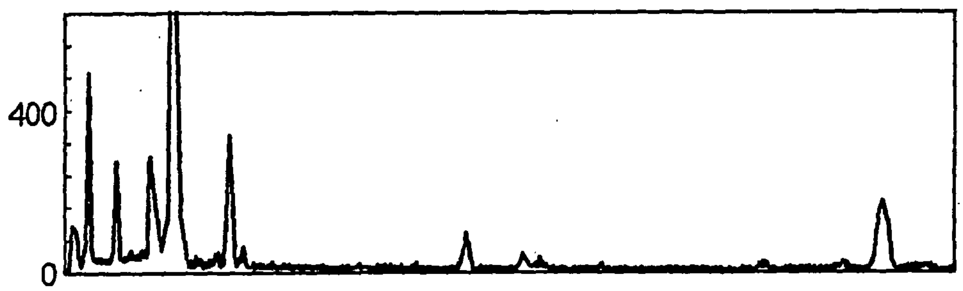

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2159079 A
- JP 49125900 A
- JP 57006713 A
- JP 2005179143 A
- JP 2005179144 A